# EUROPEAN PATENT APPLICATION

(11) **EP 4 764 563 A1**
(43) Date of publication of application: **24.06.2026**
(21) Application number: 25787027.9
(22) Date of filing: 04.03.2025
(51) Int. Cl.: G01R 31/396, G01R 31/392, G01R 31/374, G01R 31/382, G01R 31/367, G01R 31/36, G01R 31/378, H01M 4/525, H01M 4/505

(54) **BATTERY MANAGEMENT APPARATUS AND BATTERY MANAGEMENT METHOD**

(30) Priority: 11.04.2024 KR 20240048834; 06.01.2025 KR 20250001447
(71) Applicant: LG Energy Solution, Ltd., Seoul 07335 (KR)
(72) Inventor: WON, Seong Yeon, Daejeon 34122 (KR); CHOI, Chul Ho, Daejeon 34122 (KR); LIM, Jung Ho, Daejeon 34122 (KR)
(74) Representative: Plasseraud IP
(86) International application number: PCT/KR2025/002865
(87) International publication number: WO 2025/216435

(57) **Abstract**

A battery management apparatus includes an interface configured to acquire battery data of a management target battery measured at multiple degradation points, and a controller. The controller is configured to: generate a first state of charge-open circuit voltage (SOC-OCV) profile at a beginning-of-life (BOL) point and voltage-capacity profiles of the management target battery at the multiple degradation points, based on the battery data; identify a boundary voltage that distinguishes an upper voltage degradation characteristic with an upper capacity degradation rate and a lower voltage degradation characteristic with a lower capacity degradation rate, based on the voltage-capacity profiles; and estimating a second SOC-OCV profile at a middle-of-life (MOL) point, based on the upper capacity degradation rate, the lower capacity degradation rate, and the first SOC-OCV profile.

## Description

### TECHNICAL FIELD

### CROSS REFERENCE TO RELATED APPLICATION

This application is based on and claims priority from Korean Patent Application No. 10-2025-0001447 filed on January 6, 2025 and Korean Patent Application No. 10-2024-0048834 filed on April 11, 2024, with the Korean Intellectual Property Office, the disclosure of which is incorporated herein in its entirety by reference.

### Technical Field

Embodiments disclosed herein relate to a battery management apparatus and a battery management method.

### BACKGROUND ART

Recently, research and development on secondary batteries are being conducted actively. Here, secondary batteries, which are rechargeable batteries, may be interpreted as encompassing both conventional batteries such as Ni/Cd and Ni/MH batteries, as well as recent lithium-ion batteries. Among the secondary batteries, lithium-ion batteries may have a higher energy density than, for example, conventional Ni/Cd batteries and Ni/MH batteries, and may be manufactured to be small and lightweight, providing high versatility as power sources for mobile devices. Recently, lithium-ion batteries have broadened their application as power sources for electric vehicles, gaining attention as a next-generation energy storage medium.

### DISCLOSURE

### TECHNICAL PROBLEM

The embodiments disclosed herein provide a battery management apparatus and a battery management method capable of estimating a state of charge-open circuit voltage (SOC-OCV) profile changed by degradation in a nickel-cobalt-manganese (NCM) cell with an atypical composition ratio.

### TECHNICAL SOLUTION

According to an embodiment of the present disclosure, a battery management apparatus includes an interface configured to acquire battery data of a management target battery measured at multiple degradation points and a controller. The controller is configured to: generate a first state of charge-open circuit voltage (SOC-OCV) profile at a beginning-of-life (BOL) point and voltage-capacity profiles of the management target battery at the multiple degradation points, based on the battery data; identify a boundary voltage that distinguishes an upper voltage degradation characteristic with an upper capacity degradation rate and a lower voltage degradation characteristic with a lower capacity degradation rate, based on the voltage-capacity profiles; and estimate a second SOC-OCV profile at a middle-of-life (MOL) point, based on the upper capacity degradation rate, the lower capacity degradation rate, and the first SOC-OCV profile.

The battery data includes low-rate discharge data measured through low-rate discharges of about 0.1C or less at the multiple degradation points, and the controller is further configured to generate the voltage-capacity profiles based on the low-rate discharge data at the multiple degradation points.

The controller is further configured to: generate dQ/dV profiles that represent differential capacity values of the management target battery relative to voltage at the multiple degradation points, based on the low-rate discharge data; and generate the voltage-capacity profiles based on the dQ/dV profiles at the multiple degradation points.

The controller is further configured to identify the boundary voltage based on patterns of the dQ/dV profiles.

The controller is further configured to: apply the upper capacity degradation rate to the first SOC-OCV profile in the upper section of the boundary voltage and the lower capacity degradation rate to the first SOC-OCV profile in the lower section of the boundary voltage to generate a corrected SOC-OCV profile at the MOL point.

The controller is further configured to: perform interpolation on the corrected SOC-OCV profile with respect to SOC units to generate an interpolated SOC-OCV profile; and apply an open-circuit voltage (OCV) offset to the interpolated SOC-OCV profile to estimate the second SOC-OCV profile.

The management target battery includes an NCM battery containing nickel, cobalt, and manganese, and the upper voltage degradation characteristic and the lower voltage degradation characteristic arise due to compositional elements of the NCM battery.

The upper voltage degradation characteristic is determined based on capacity degradation caused by a redox reaction of nickel and cobalt, and the lower voltage degradation characteristic is determined based on capacity manifestation caused by a redox reaction of manganese.

According to an embodiment of the present disclosure, a battery management method includes: acquiring battery data of a management target battery measured multiple degradation points; generating a first state of charge-open circuit voltage (SOC-OCV) profile at a beginning-of-life (BOL) point and voltage-capacity profiles of the management target battery at the multiple degradation points, based on the battery data; identifying a boundary voltage that distinguishes an upper voltage degradation characteristic with an upper capacity degradation rate and a lower voltage degradation characteristic with a lower capacity degradation rate, based on the voltage-capacity profiles; and estimating a second SOC-OCV profile at a middle-of-life (MOL) point, based on the upper capacity degradation rate, the lower capacity degradation rate, and the first SOC-OCV profile.

The battery data includes low-rate discharge data measured through low-rate discharges of about 0.1C or less at the multiple degradation points, and the generating the voltage-capacity profiles includes generating the voltage-capacity profiles based on the low-rate discharge data at the multiple degradation points.

The generating the voltage-capacity profiles includes: generating dQ/dV profiles representing differential capacity values of the management target battery relative to voltage at the multiple degradation points, based on the low-rate discharge data; and generating the voltage-capacity profiles based on the dQ/dV profiles at the multiple degradation points.

The identifying the boundary voltage includes: identifying the boundary voltage based on patterns of the dQ/dV profiles.

The estimating the second SOC-OCV profile includes: applying the upper capacity degradation rate to the first SOC-OCV profile in the upper section of the boundary voltage and the lower capacity degradation rate to the first SOC-OCV profile in the lower section of the boundary voltage to generate a corrected SOC-OCV profile at the MOL point.

The estimating the second SOC-OCV profile includes: performing interpolation on the corrected SOC-OCV profile with respect to SOC units to generate an interpolated SOC-OCV profile; and applying an open-circuit voltage (OCV) offset to the interpolated SOC-OCV profile to estimate the second SOC-OCV profile.

The management target battery includes an NCM battery containing nickel, cobalt, and manganese, and the upper voltage degradation characteristic and the lower voltage degradation characteristic arise due to compositional elements of the NCM battery.

The upper voltage degradation characteristic is determined based on capacity degradation caused by a redox reaction of nickel and cobalt, and the lower voltage degradation characteristic is determined based on capacity manifestation caused by a redox reaction of manganese.

According to an embodiment of the present disclosure, a non-transitory computer-readable storage medium stores a program that, when executed, causes a computer to perform a method. The method includes: acquiring battery data of a management target battery measured at multiple degradation points; generating a first state of charge-open circuit voltage (SOC-OCV) profile at a beginning-of-life (BOL) point and voltage-capacity profiles of the management target battery at the multiple degradation points, based on the battery data; identifying a boundary voltage that distinguishes an upper voltage degradation characteristic with an upper capacity degradation rate and a lower voltage degradation characteristic with a lower capacity degradation rate, based on the voltage-capacity profiles; and estimating a second SOC-OCV profile at a middle-of-life (MOL) point, based on the upper capacity degradation rate, the lower capacity degradation rate, and the first SOC-OCV profile.

### ADVANTAGEOUS EFFECTS

The embodiments disclosed herein may provide a battery management apparatus and a battery management method capable of estimating a SOC-OCV profile changed by degradation in an NCM cell with an atypical composition ratio.

The technical effects according to the embodiments disclosed herein are not limited to the above-mentioned effects, and other effects not mentioned above will be clearly understood by a person ordinarily skilled in the art according to the disclosure of this document.

### DESCRIPTION OF DRAWINGS

The drawings attached herewith are merely illustrative of embodiments of the present disclosure, and take on the role of further facilitating the understanding of the technical idea of the present disclosure along with the descriptions herein. Thus, the present disclosure should not be construed as being limited to those illustrated in the drawings.
FIG. 1 is a view illustrating the elements of a battery management system according to some embodiments.
FIG. 2 is a view illustrating the elements of a battery management apparatus according to some embodiments.
FIG. 3 is a graph illustrating an SOC-OCV profile that remains unchanged even as degradation progresses in a conventional NCM battery cell.
FIG. 4 is a graph illustrating the capacity degradation occurring uniformly across the entire voltage range in a conventional NCM battery cell.
FIG. 5 is a graph illustrating an SOC-OCV profile in an Mn-rich NCM battery cell according to some embodiments changing due to degradation.
FIG. 6 is a graph illustrating the capacity degradation occurring differently in the low-voltage region and the high-voltage region of a Mn-rich NCM battery cell according to some embodiments.
FIG. 7 is a view illustrating the changes in an SOC-OCV profile as a Mn-rich NCM battery cell according to some embodiments degrades from a BOL point to a MOL point.
FIG. 8 is a view illustrating the changes in the distinction between an upper voltage and a lower voltage based on a boundary voltage due to battery degradation according to some embodiments.
FIG. 9 is a graph illustrating the comparison results between the estimated values of a second SOC-OCV profile and actual measured values at a MOL point according to some embodiments.
FIG. 10 is a table illustrating the process of generating a second SOC-OCV profile according to some embodiments.
FIG. 11 is a flowchart illustrating the steps of a battery management method according to some embodiments.

### MODE FOR INVENTION

Hereinafter, embodiments described herein will be described with reference to the attached drawings. However, this is not intended to limit the present disclosure to specific embodiments, and should be understood to include various modifications, equivalents, and/or alternatives to the embodiments described herein.

The embodiments described herein and the terms used are not intended to limit the technical features described herein to specific embodiments and should be understood to include various modifications, equivalents, or substitutes of the embodiments. In relation to the description of the drawings, similar reference numerals may be used for similar or related components. The singular form of a noun corresponding to an item may include one or more instances of the item unless the relevant context clearly indicates otherwise.

Herein, each of phrases, such as "A or B," "at least one of A and B," "at least one of A or B," "A, B, or C," "at least one of A, B, and C," and "at least one of A, B, or C," may include any one of the items listed together in the corresponding phrase or all possible combinations of these items. Terms such as "first," "second," "primary," "secondary," "A," "B," "(a)," or "(b)" may be used to distinguish the corresponding component from other corresponding components, and, unless specifically stated otherwise, do not limit the components in other respects (e.g., importance or order).

Herein, when a certain (e.g., first) component is described as being "connected," "coupled," or "linked" to another (e.g., second) component, either functionally or communicatively, with or without these terms, it means that the certain component may be connected directly (e.g., by wire or wirelessly) or indirectly (e.g., via a third component) to the other component.

Methods according to various embodiments disclosed herein may be included in and provided as a computer program product. The computer program product may be traded as a product between a seller and a purchaser. The computer program product may be distributed in the form of a machine-readable storage medium (e.g., compact disc read only memory (CD-ROM)), or may be distributed (e.g., downloaded or uploaded) online through an application store or directly between two driver devices. In the case of online distribution, at least part of the computer program product may be temporarily stored or produced in a machine-readable storage medium such as a manufacturer's server, a server of an application store, or the memory of a relay server.

According to the embodiments disclosed herein, each of the above-described components (e.g., module or program) may include either a single entity or multiple entities, and some of the multiple entities may be placed separately from other components. According to the embodiments disclosed herein, one or more of the above-described components or operations may be omitted, or one or more other components or operations may be added. Alternatively or additionally, multiple components (e.g., modules or programs) may be integrated into a single component. In such a case, the integrated component may perform one or more functions of each of the multiple components in the same or a similar manner as performed by the corresponding one of the multiple components before the integration.

According to the embodiments disclosed herein, operations performed by a module, a program, or other components may be executed sequentially, in parallel, repetitively, or heuristically, one or more of the operations may be executed in a different order or omitted, or one or more other operations may be added.

The term "and/or" includes a combination of a plurality of related listed items or any of a plurality of related listed items.

As used in this specification, the terms "about," "approximately," and "substantially" are understood to refer to a range or approximation of a numerical value or degree, considering inherent manufacturing and material tolerances.

An NCM battery cell may contain nickel, cobalt, and manganese as cathode materials. For example, the cathode of the NCM cell may include LiNiₓMn_{y}Co_{z}O₂, where x + y + z = 1. Unlike such a conventional NCM cell, a Mn (manganese)-rich cell with a higher Mn content and additional inclusion of Li₂MnO₃ as a cathode material may be used. That is, the Mn-rich cell may include Li₂MnO₃-LiNi_{x'}Mn_{y'}Co_{z'}O₂, where x' + y' + z' = 1, the ratio of Mn may be high, and the ratio of Co may be extremely low.

In the conventional NCM cell, the mapping relationship between the state of charge (SOC) and the open-circuit voltage (OCV) may not be significantly affected by cell degradation. Therefore, in the case of the conventional NCM cell, the control algorithm of the battery management system (BMS) may operate normally even when the SOC-OCV profile established at the beginning of life (BOL) is applied at the middle of life (MOL). However, in the case of the Mn-rich cell, the SOC-OCV mapping relationship may change due to the cell degradation, leading to a problem where the use of the SOC-OCV profile at the BOL point may affect the control algorithm of the BMS. Considering these problems, the present disclosure provides a battery management apparatus and a battery management method capable of estimating a SOC-OCV profile that changes due to the cell degradation, for example, in a Mn-rich NCM battery cell.

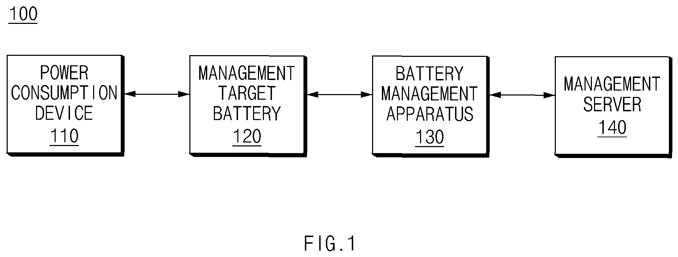

FIG. 1 illustrates the elements of a BMS according to some embodiments.

Referring to FIG. 1, a system 100 may include a power consumption device 110, a management target battery 120, and a battery management apparatus 130. However, the present disclosure is not limited thereto, and some components may be omitted from the system 100, or additional general-purpose components may be further included in the system 100.

The power consumption device 110 may be configured to charge or discharge the management target battery 120. The power consumption device 110 may discharge the management target battery 120 by consuming power and charge the management target battery 120 by generating power. According to an embodiment, the power consumption device 110 may include a mobility device such as an electric vehicle (EV), a hybrid electric vehicle (HEV), or an electric bike. The mobility device may drive a motor based on the power of the management target battery 120 or charge the management target battery 120 using the power generated through regenerative braking.

The management target battery 120 may include, for example, a battery pack subject to diagnosis in the system 100. The battery pack of the management target battery 120 may include multiple battery modules, and each battery module may include multiple battery cells. According to an embodiment, the management target battery 120 may be installed in various types of mobility devices.

The battery management apparatus 130 may perform operations for diagnosing or managing the management target battery 120. The battery management apparatus 130 may acquire battery data from the management target battery 120 and diagnose or manage the state of the management target battery 120 based on the acquired battery data. According to an embodiment, the battery management apparatus 130 may include an onboard BMS configured with the management target battery 120, and/or an offboard external apparatus remotely located from the management target battery 120. The external apparatus may include, for example, a charger at a battery charging station, a battery diagnostic device, or a cloud computing server.

The system 100 may further include a management server 140. The management server 140 may manage the results of management of the battery management apparatus 130. The management server 140 may exchange data with the battery management apparatus 130 via wired or wireless communication. When a defect in the management target battery 120 is diagnosed or the lifespan of the management target battery 120 is predicted, the results may be transmitted to the management server 140 and recorded in a database. According to an embodiment, the battery management apparatus 130 may perform diagnostic operations by executing a battery management software, and the management server 140 may provide the update information for the battery management software to the battery management apparatus 130.

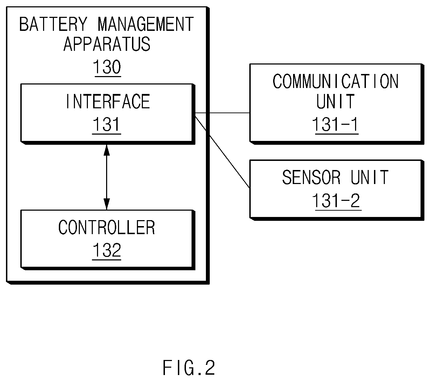

FIG. 2 is a view illustrating the elements of a battery management apparatus 130 according to some embodiments.

Referring to FIG. 2, the battery management apparatus 130 may include an interface 131 and a controller 132. However, the present disclosure is not limited thereto, and some components may be omitted from the battery management apparatus 130, or other general components may be further included in the battery management apparatus 130.

The interface 131 may acquire battery data from the management target battery 120. According to an embodiment, the interface 131 may include a communication unit 131-1 configured to receive the battery data and/or a sensor unit 131-2 configured to measure the battery data. According to an embodiment, when the battery management apparatus 130 is implemented in an offboard form, the communication unit 131-1 may receive the battery data through methods such as wired data communication or wireless data communication. Alternatively, when the battery management apparatus 130 is implemented in an onboard form, the sensor unit 131-2 may be configured to measure values such as voltage, current, temperature, and resistance from the management target battery 120.

The controller 132 may have a structure for executing instructions that implement the operations of the battery management apparatus 130. The controller 132 may be implemented as an array of multiple logic gates or a general-purpose microprocessor for processing various operations, and may be configured with a single processor or a plurality of processors. For example, the controller 132 may be implemented in the form of at least one of a microprocessor, a central processing unit (CPU), a graphics processing unit (GPU), and an access point (AP).

The controller 132 may operate in conjunction with a memory configured to store, for example, various data, commands, mobile applications, and computer programs. The memory may store operational data for various programs related to the operation of the system 100 required for the operation of the controller 132. When necessary, multiple memory units may be provided. The memory may be configured separately from or integrated with the controller 132. The controller 132 may execute commands stored in the memory to process various computations. For example, the memory may be implemented as non-volatile devices, such as read-only memory (ROM), programmable read-only memory (PROM), erasable programmable read-only memory (EPROM), electrically erasable programmable read-only memory (EEPROM), flash memory, phase-change random access memory (PRAM), magnetoresistive random access memory (MRAM), resistive random access memory (RRAM), and ferroelectric random access memory (FRAM), or volatile devices such as dynamic random access memory (DRAM), static random access memory (SRAM), synchronous dynamic random access memory (SDRAM). In addition, the memory may be implemented in the form of, for example, hard disk drive (HDD), solid state disk (SSD), secure digital (SD), micro-SD, or a combination thereof.

The interface 131 may be configured to acquire battery data of the management target battery 120 measured at multiple degradation points. The multiple degradation points may include points with regular time intervals and/or specific charge-discharge cycles starting from a BOL point. The multiple degradation points may include a MOL point, which, for example, may correspond to the time after completing 100 charge-discharge cycles. The battery data may include parameters such as voltage, current, temperature, and resistance of the management target battery 120. The interface 131 may include a communication unit 131-1 and/or a sensor unit 131-2, where the battery data may be received through the communication unit 131-1 or measured by the sensor unit 131-2.

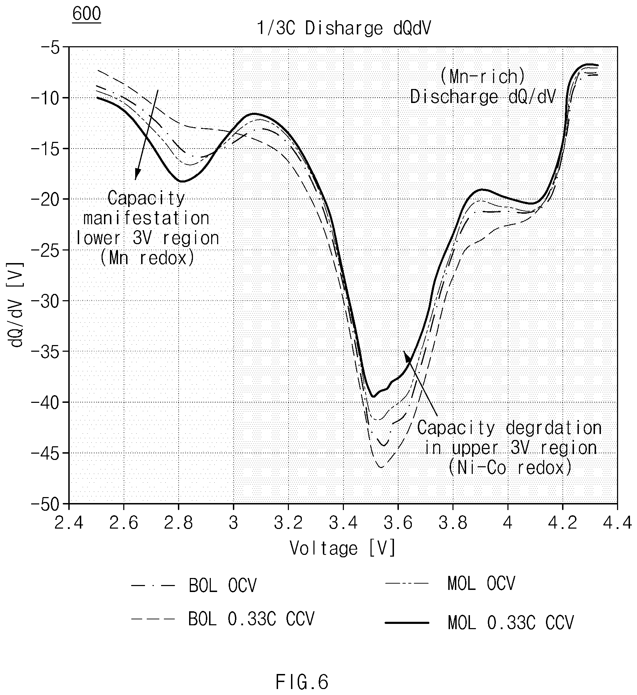

The controller 132 may be configured to generate a first SOC-OCV profile at the beginning-of-life (BOL) point and voltage-capacity profiles of the management target battery 120 at multiple degradation points based on the battery data. The first SOC-OCV profile at the BOL point may be generated in the form of, for example, a table or a curve based on the mapping relationship of SOC values corresponding to respective unit OCV values. For example, the unit OCV values may be formed at 10% intervals, such as 100%, 90%, 80%, and so on, and specific values may be changed as needed. The voltage-capacity profile may include, for example, graphs or curves showing how the capacity (Q) and/or the rate of change of capacity with respect to voltage (dQ/dV) vary as the cell voltage (V) changes. For details on the voltage-capacity profile, FIG. 6 described later may be referred to.

The controller 132 may be configured to identify a boundary voltage that distinguishes an upper voltage degradation characteristic with an upper capacity degradation rate and a lower voltage degradation characteristic with a lower capacity degradation rate based on the voltage-capacity profiles. When the voltage-capacity profiles at multiple degradation points are displayed together, the degradation trends may differ based on a specific voltage, which may be selected as the boundary voltage. In the upper voltage region above the boundary voltage, the upper voltage degradation characteristic may be observed, while in the lower voltage region below the boundary voltage, the lower voltage degradation characteristic may be observed. As the battery degradation progresses from the BOL point to the MOL point, the upper voltage region may degrade by the upper capacity degradation rate, and the lower voltage region may degrade by the lower capacity degradation rate. For details on the boundary voltage, FIG. 6 described later may be referred to.

The controller 132 may be configured to estimate a second SOC-OCV profile at the middle of life (MOL) point based on the upper capacity degradation rate, the lower capacity degradation rate, and the first SOC-OCV profile. Since different degradation characteristics appear in the upper voltage region and the lower voltage region, in order to estimate the second SOC-OCV profile at the MOL point, it may be necessary to distinguish the upper voltage region and the lower voltage region and apply the upper capacity degradation rate and the lower capacity degradation rate separately. After applying the upper and lower capacity degradation rates to the first SOC-OCV profile, an additional correction process may be performed to generate the second SOC-OCV profile at the MOL point.

According to an embodiment, the battery data may include low-rate discharge data measured through low-rate discharging of the management target battery 120 at approximately 0.1C or less at multiple degradation points, and the controller 132 may be configured to generate voltage-capacity profiles based on the low-rate discharge data at the multiple degradation points. For example, the voltage-capacity profiles shown in FIG. 6 may be measured based on low-rate discharging, which may be performed with a discharge current of about 0.1C or less. For instance, the low-rate discharge current may be, for example, about 0.05C or about 0.033C. At the multiple degradation points, parameters such as voltage, current, temperature, and resistance during low-rate discharging may be measured, and based on these parameters, for example, the capacity (Q) and dQ/dV may be calculated.

According to an embodiment, the controller 132 may be configured to generate dQ/dV profiles representing the differential capacity values (dQ/dV) with respect to voltage at multiple degradation points based on low-rate discharge data and to generate voltage-capacity profiles based on the dQ/dV profiles at the multiple degradation points. Through low-rate discharging, parameters such as voltage, current, temperature, and resistance at the multiple degradation points may be measured, and the capacity (Q) values may be calculated using computational algorithms based on these measurements. By differentiating the capacity (Q) values with respect to voltage, dQ/dV values may be computed, and by plotting the dQ/dV values with respect to voltage (V), dQ/dV profiles may be generated. The voltage-capacity profiles may include these dQ/dV profiles corresponding to the multiple degradation points.

According to an embodiment, the controller 132 may be configured to identify a boundary voltage based on the patterns of the dQ/dV profiles. For example, a region where the dQ/dV profiles show an increasing pattern for multiple degradation points and a region where the dQ/dV profiles show a decreasing pattern may be distinguished, and a voltage value near the position where this distinction occurs may be set as the boundary voltage.

According to an embodiment, the controller 132 may be configured to apply the upper capacity degradation rate to the first SOC-OCV profile in the upper section of the boundary voltage and to apply the lower capacity degradation rate to the first SOC-OCV profile in the lower section of the boundary voltage to generate a corrected SOC-OCV profile at the MOL point. When the NCM cell is a Mn-rich cell, applying the SOC-OCV profile at the BOL point to the MOL point may cause distortion. Therefore, corrections may be performed by applying the capacity degradation rates to the first SOC-OCV profile at the BOL point, and the corrections may be independently performed for the upper and lower sections based on the boundary voltage.

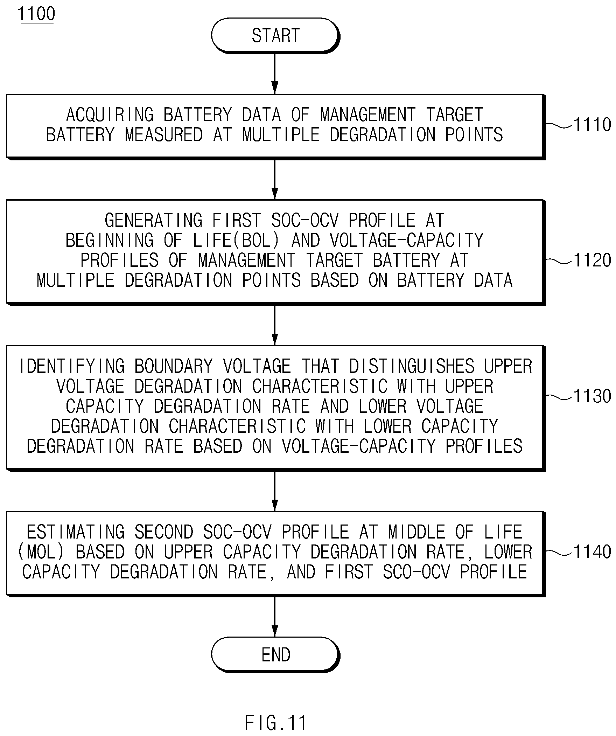

According to an embodiment, the controller 132 may be configured to perform interpolation on the corrected SOC-OCV profile with respect to SOC units to generate an interpolated SOC-OCV profile and to apply an OCV offset to the interpolated SOC-OCV profile to estimate the second SOC-OCV profile. For details on interpolation and offset, FIG. 11 described later may be referred to. The interpolation process may resolve mismatches caused by corrections of reference SOC values at the BOL point. The offset process may collectively adjust the overall values to improve the accuracy of the second SOC-OCV profile.

According to an embodiment, the management target battery 120 may include an NCM battery containing nickel, cobalt, and manganese, and the upper voltage degradation characteristic and the lower voltage degradation characteristic may arise due to the compositional elements of the NCM battery. For example, the voltage region-specific degradation characteristics of the NCM battery may be determined based on the voltage region where a redox reaction of nickel primarily occurs, the voltage region where a redox reaction of cobalt primarily occurs, and the voltage region where a redox reaction of manganese primarily occur.

According to an embodiment, the upper voltage degradation characteristic may be determined based on capacity degradation caused by a redox reaction of nickel and cobalt, and the lower voltage degradation characteristic is determined based on capacity manifestation caused by a redox reaction of manganese. According to an embodiment, the NCM battery may be an Mn-rich NCM battery, where the redox reaction of high-content manganese may have a dominant effect on the lower section of the boundary voltage, while the redox reaction of nickel and cobalt may have a dominant effect on the upper section of the boundary voltage.

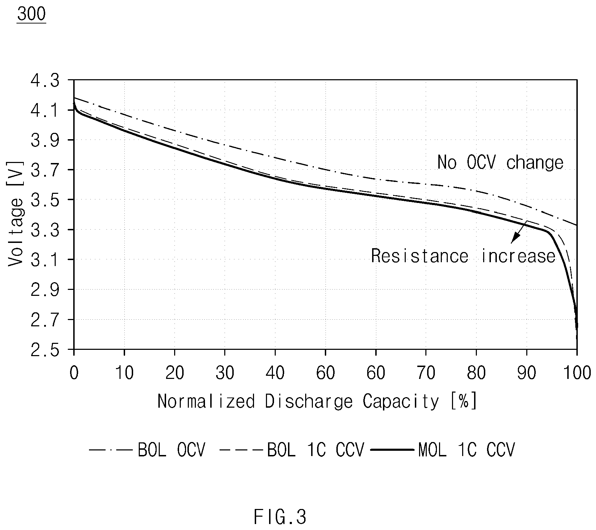

FIG. 3 illustrates an SOC-OCV profile that remains unchanged even as degradation progresses in a conventional NCM battery cell.

Referring to FIG. 3, Graph 300 illustrates an SOC-OCV profile remaining unchanged despite the progression of degradation in a conventional NCM battery cell.

In Graph 300, the closed-circuit voltage (CCV) at the state of about 1C may exhibit different profiles at the BOL and MOL points, and the cause for the different profiles may be an increase in resistance due to battery degradation. In contrast, in a conventional NCM battery cell without a high manganese content, the SOC-OCV profile may not change even as the battery degradation progresses.

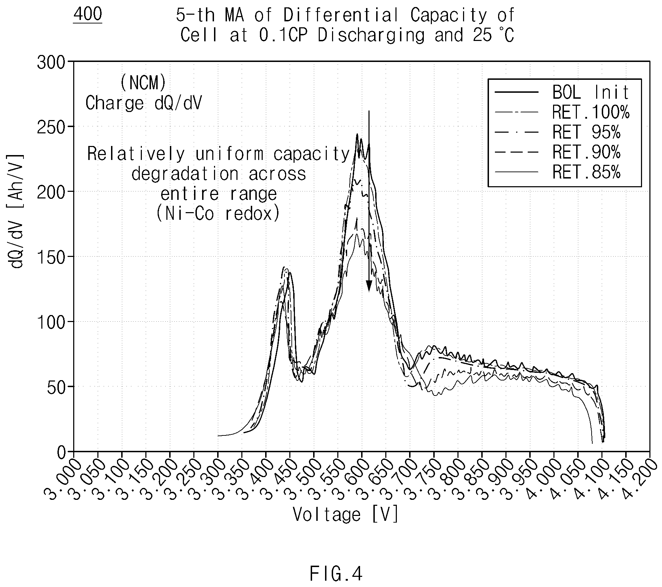

FIG. 4 illustrates the capacity degradation occurring uniformly across the entire voltage range in a conventional NCM battery cell.

Referring to FIG. 4, Graph 400 illustrates the capacity degradation occurring uniformly across the entire voltage range in a conventional NCM battery cell.

In Graph 400, capacity degradation may occur relatively uniformly across the entire voltage range, and thus the SOC-OCV profiles may not exhibit significant differences at the BOL and MOL points.

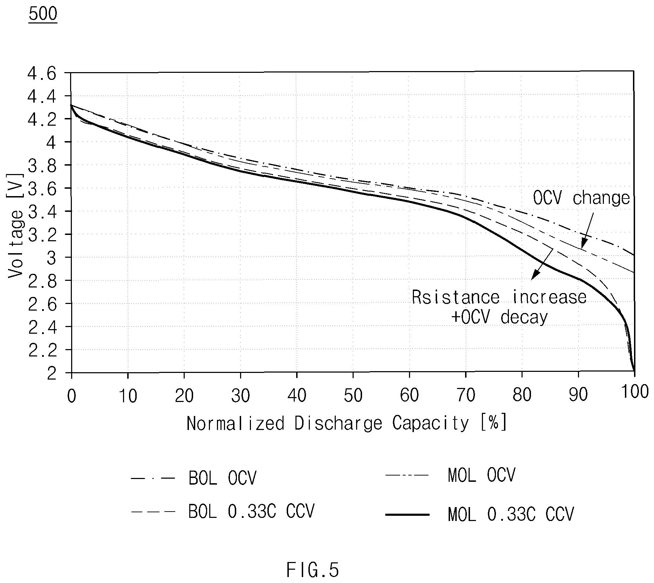

FIG. 5 illustrates an SOC-OCV profile in an Mn-rich NCM battery cell according to some embodiments changing due to degradation.

Referring to FIG. 5, Graph 500 illustrates an SOC-OCV profile changing due to degradation in an Mn-rich NCM battery cell. Graph 500 may represent an Mn-rich NCM cell.

In the Mn-rich NCM cell represented by Graph 500, the closed-circuit voltage (CCV) at about 0.33C may degrade at the MOL point compared to the BOL point. In addition, the OCV may also degrade at the MOL point compared to the BOL point. Therefore, in the case of the Mn-rich NCM cell, it may be difficult to directly use the SOC-OCV profile generated at the BOL point at the MOL point.

FIG. 6 illustrates capacity degradation occurring differently in the low-voltage region and the high-voltage region of a Mn-rich NCM battery cell according to some embodiments.

Referring to FIG. 6, Graph 600 illustrates the capacity degradation occurring differently in the low-voltage region and the high-voltage region of a Mn-rich NCM battery cell.

In graph 600, about 3 V may be selected as a boundary voltage, and the boundary voltage may distinguish the lower voltage region and the upper voltage region. In the lower voltage region, as degradation progresses, the dQ/dV values may decrease, whereas in the upper voltage region, the dQ/dV values may increase as degradation progresses. In the lower voltage region, the redox reaction of manganese may have a dominant effect due to the high manganese content, and in the upper voltage region, the redox reaction of nickel and cobalt may have a dominant effect.

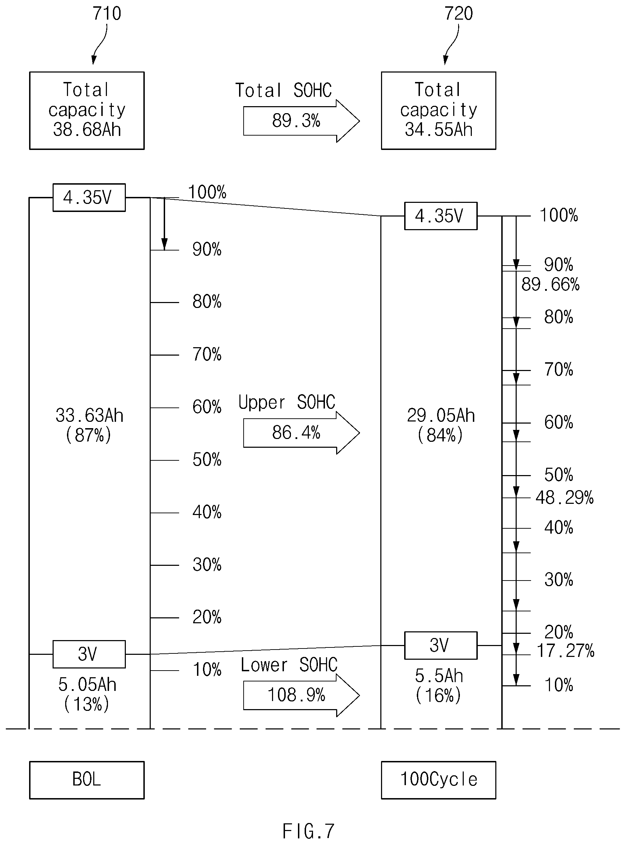

FIG. 7 illustrates how an SOC-OCV profile changes as a Mn-rich NCM battery cell according to some embodiments degrades from a BOL point to a MOL point.

Referring to FIG. 7, the mapping relationship between OCV and SOC at a BOL point 710 and a MOL point 720 may be illustrated. At the BOL point 710 and the MOL point 720, the OCV may be distinguished into an upper voltage region and a lower voltage region based on the boundary voltage of 3 V. For example, the MOL point 720 may correspond to the point after 100 charge-discharge cycles have been performed.

First, at the BOL point 710, the total capacity of the NCM cell may be 38.68 Ah, while the degraded total capacity of the NCM cell at the MOL point 720 may be 34.55 Ah. Second, at the BOL point 710, the boundary voltage of 3 V may correspond to 5.05 Ah and 13% SOC, whereas at the MOL point 720, the boundary voltage of 3 V may correspond to 5.5 Ah and 16% SOC. Third, at the BOL point 710, the upper voltage region may correspond to 33.63 Ah, while at the MOL point 720, the upper voltage region may correspond to 29.05 Ah.

The total capacity of 34.55 Ah at the MOL point 720 may be 89.3% of the total capacity of 38.68 Ah at the BOL point 710. The capacity of 29.05 Ah at the upper voltage region at the MOL point 720 may be 86.4% of 33.63 Ah at the upper voltage region at the BOL point 710. The capacity of 5.5 Ah at the lower voltage region at the MOL point 720 may be 108.9% of 5.05 Ah at the lower voltage region at the BOL point 710.

In this case, the upper capacity degradation rate in the upper voltage region may be 89.3/86.4 = 1.034, and the lower capacity degradation rate in the lower voltage region may be 89.3/108.9 = 0.819. Therefore, the OCV value corresponding to SOC 90% (= DOD (depth of discharge) 10%) at the BOL point 710 may correspond to DOD 10% * 1.034 = DOD 10.34% (= SOC 89.66%) at the MOL point 720. In this manner, the SOC-OCV profile at the MOL point 720 may be reconstructed based on the SOC-OCV profile at the BOL point 710.

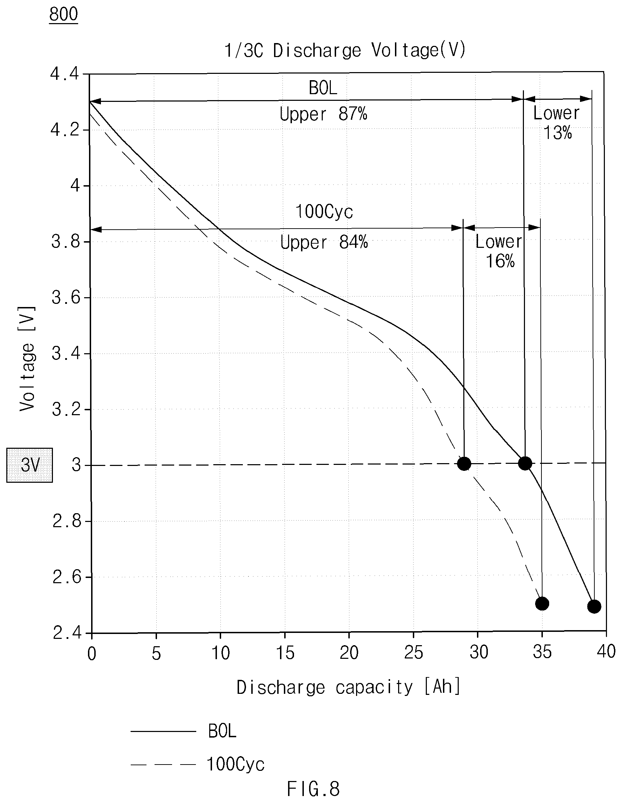

FIG. 8 illustrates how the distinction between the upper voltage and the lower voltage based on the boundary voltage due to a battery degradation according to some embodiments changes.

Referring to FIG. 8, Graph 800 may be illustrated to represent a first SOC-OCV profile at a BOL point and a second SOC-OCV profile at a MOL point.

Graph 800 may indicate that the SOC-OCV profile may change when degradation progresses from the BOL point to the MOL point. The upper voltage region and the lower voltage region may be distinguished based on the boundary voltage of 3 V. The distinction ratio between the upper voltage region and the lower voltage region may change due to degradation from the BOL point to the MOL point.

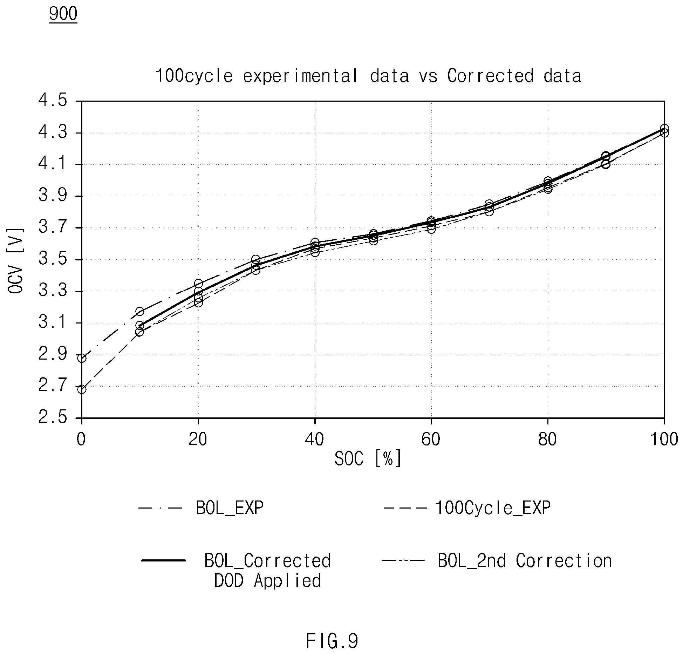

FIG. 9 illustrates the comparison results between the estimated values of the second SOC-OCV profile and the actual measured values at the MOL point according to some embodiments.

Referring to FIG. 9, Graph 900 illustrates the comparison results between the estimated values of the second SOC-OCV profile and the actual measured values at the MOL point.

In Graph 900, BOL_EXP may represent the first SOC-OCV profile measured at the BOL point, and 100Cycle_EXP may represent the SOC-OCV profile measured at the MOL point. As illustrated, it may be observed that differences arise between the two profiles in an Mn-rich NCM cell. However, since generating the SOC-OCV profile at the MOL point through actual measurements requires significant time and cost, a technique for estimating the profile instead of actual measurement may be needed.

By applying the upper capacity degradation rate and the lower capacity degradation rate to the first SOC-OCV profile (BOL_EXP), a corrected SOC-OCV profile (BOL_Corrected DOD Applied) may be generated, and a second SOC-OCV profile (BOL_2nd Correction) may be generated by a second correction that collectively applies an offset to the generated corrected SOC-OCV profile. As illustrated, it may be observed that there is no significant difference between the second SOC-OCV profile (BOL_2nd Correction) and the actual measured SOC-OCV profile (100Cycle_EXP).

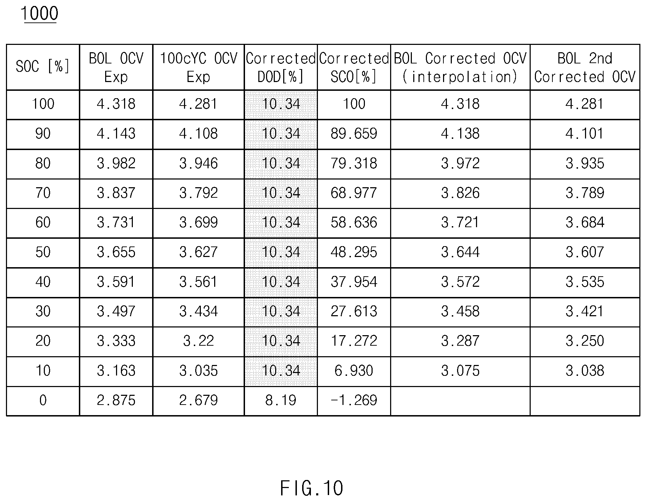

FIG. 10 illustrates a process of generating a second SOC-OCV profile according to some embodiments.

Referring to FIG. 10, Table 1000 illustrates a process of generating a second SOC-OCV profile.

The first and second columns of Table 1000 may represent a first SOC-OCV profile at a BOL point. The first SOC-OCV profile is generated in units of SOC 10%, but may be generated in other units when needed. The third column of Table 1000 may represent a SOC-OCV profile actually measured at a MOL point, and generating an estimated profile similar thereto may be one of the purposes of the present disclosure.

The fifth column of Table 1000 may represent a corrected SOC-OCV profile generated by applying the upper capacity degradation rate and the lower capacity degradation rate to the first SOC-OCV profile. In order to generate the corrected SOC-OCV profile in the fifth column, the upper capacity degradation rate and the lower capacity degradation rate from the fourth column may be used.

The sixth column of Table 1000 may represent an interpolated SOC-OCV profile generated by performing interpolation on the corrected SOC-OCV profile. The seventh column of Table 1000 may represent a second SOC-OCV profile generated by collectively shifting the interpolated SOC-OCV profile by a specific offset value. As illustrated, it may be observed that the difference between the second SOC-OCV profile in the seventh column and the actual measured SOC-OCV profile in the third column is not significant.

FIG. 11 illustrates the steps of a battery management method 1100 according to some embodiments.

Referring to FIG. 11, the battery management method 1100 may include steps 1110 to 1140. However, without being limited thereto, some steps may be omitted or other general-purpose steps may be added, and the steps of the battery management method 1100 may be executed in a different order from the illustrated order.

The battery management method 1100 may include steps processed in time series by the battery management apparatus 130. Therefore, even when a description is omitted below, the descriptions above regarding the battery management apparatus 130 may be equally applicable to the battery management method 1100.

Steps 1110 to 1140 of the battery management method 1100 may be performed by the sensor 131 and the controller 132 of the battery management apparatus 130.

At step 1110, the battery management apparatus 130 may perform a step of acquiring battery data of a management target battery 120 measured at multiple degradation points.

At step 1120, the battery management apparatus 130 may perform a step of generating a first SOC-OCV profile at a beginning-of-life (BOL) point and voltage-capacity profiles of the management target battery 120 at multiple degradation points based on the battery data.

At step 1130, the battery management apparatus 130 may perform a step of identifying a boundary voltage that distinguishes an upper voltage degradation characteristic with an upper capacity degradation rate and a lower voltage degradation characteristic with a lower capacity degradation rate, based on the voltage-capacity profiles.

At step 1140, the battery management apparatus 130 may perform a step of estimating the second SOC-OCV profile at the middle of life (MOL) point based on the upper capacity degradation rate, the lower capacity degradation rate, and the first SOC-OCV profile.

According to an embodiment, the battery management method 1100 may be implemented in the form of a computer program stored in a computer-readable storage medium. That is, the computer program may include instructions for implementing the battery management method 1100, and the instructions of the program may be stored in a computer-readable storage medium. The computer program may include a mobile application.

According to an embodiment, the computer-readable storage medium may include a magnetic medium such as a hard disk, a floppy disk, or a magnetic tape, an optical medium such as a CD-ROM or a DVD, a magneto-optical medium such as a floptical disk, and a hardware device configured specifically to store and execute computer program instructions, such as ROM, RAM, or flash memory. Computer program instructions may include a machine language code created by a compiler and high-level language code capable of being executed by a computer using, for example, an interpreter.

The terms such as "include," "comprise," or "have," as used above, indicate that the corresponding component may be inherent, unless explicitly stated otherwise. Therefore, these terms should not be interpreted as excluding other components, but rather as being capable of further including other components. All terms, including technical or scientific terms, have the same meaning as generally understood by a person ordinarily skilled in the art to which the embodiments disclosed herein pertain, unless otherwise defined. Commonly used terms, as defined in dictionaries, should be interpreted as consistent with the context of the relevant technology, and should not be interpreted in an idealized or overly formal sense unless explicitly defined herein.

The foregoing description is merely an exemplary explanation of the technical idea disclosed herein. A person ordinarily skilled in the technical field to which the embodiments disclosed herein belong will be able to make various modifications and variations without departing from the essential characteristics of the embodiments disclosed herein. Accordingly, the embodiments disclosed herein are not intended to limit the technical idea of the embodiments disclosed herein, but rather to explain them, and the scope of the technical idea disclosed herein is not limited by these embodiments. The scope of protection of the technical idea disclosed herein should be interpreted in accordance with the claims below, and all technical ideas within the scope equivalent to the protection scope shall be interpreted as being included in the scope of rights of the present disclosure. Therefore, the technical scope of various embodiments of the present disclosure should not be limited to the detailed description provided in the specification, but should be defined by the claims.

## Claims

1. A battery management apparatus, comprising:
an interface configured to acquire battery data of a management target battery measured at multiple degradation points; and
a controller,
wherein the controller is configured to:
generate a first state of charge-open circuit voltage (SOC-OCV) profile at a beginning-of-life (BOL) point and voltage-capacity profiles of the management target battery at the multiple degradation points, based on the battery data;
identify a boundary voltage that distinguishes an upper voltage degradation characteristic with an upper capacity degradation rate and a lower voltage degradation characteristic with a lower capacity degradation rate, based on the voltage-capacity profiles; and
estimate a second SOC-OCV profile at a middle-of-life (MOL) point, based on the upper capacity degradation rate, the lower capacity degradation rate, and the first SOC-OCV profile.

2. The battery management apparatus according to claim 1, wherein the battery data includes low-rate discharge data measured through low-rate discharges of 0.1C or less at the multiple degradation points, and
wherein the controller is further configured to: generate the voltage-capacity profiles based on the low-rate discharge data at the multiple degradation points.

3. The battery management apparatus according to claim 2, wherein the controller is further configured to:
generate dQ/dV profiles representing differential capacity values of the management target battery relative to voltage at the multiple degradation points, based on the low-rate discharge data; and
generate the voltage-capacity profiles based on the dQ/dV profiles at the multiple degradation points.

4. The battery management apparatus according to claim 3, wherein the controller is further configured to:
identify the boundary voltage based on patterns of the dQ/dV profiles.

5. The battery management apparatus according to claim 1, wherein the controller is further configured to:
apply the upper capacity degradation rate to the first SOC-OCV profile at an upper section of the boundary voltage and the lower capacity degradation rate to the first SOC-OCV profile at a lower section of the boundary voltage to generate a corrected SOC-OCV profile at the MOL point.

6. The battery management apparatus according to claim 5, wherein the controller is further configured to:
perform interpolation on the corrected SOC-OCV profile with respect to SOC units to generate an interpolated SOC-OCV profile; and
apply an open-circuit voltage (OCV) offset to the interpolated SOC-OCV profile to estimate the second SOC-OCV profile.

7. The battery management apparatus according to claim 1, wherein the management target battery includes an NCM battery containing nickel, cobalt, and manganese, and
wherein the upper voltage degradation characteristic and the lower voltage degradation characteristic arise due to compositional elements of the NCM battery.

8. The battery management apparatus according to claim 7, wherein the upper voltage degradation characteristic is determined based on capacity degradation caused by a redox reaction of nickel and cobalt, and wherein the lower voltage degradation characteristic is determined based on capacity manifestation caused by a redox reaction of manganese.

9. A battery management method, comprising:
acquiring battery data of a management target battery measured at multiple degradation points;
generating a first state of charge-open circuit voltage (SOC-OCV) profile at a beginning-of-life (BOL) point and voltage-capacity profiles of the management target battery at the multiple degradation points, based on the battery data;
identifying a boundary voltage that distinguishes an upper voltage degradation characteristic with an upper capacity degradation rate and a lower voltage degradation characteristic with a lower capacity degradation rate, based on the voltage-capacity profiles; and
estimating a second SOC-OCV profile at a middle-of-life (MOL) point, based on the upper capacity degradation rate, the lower capacity degradation rate, and the first SOC-OCV profile.

10. The battery management method according to claim 9, wherein the battery data includes low-rate discharge data measured through low-rate discharges of 0.1C or less at the multiple degradation points, and
wherein the generating the voltage-capacity profiles includes:
generating the voltage-capacity profiles based on the low-rate discharge data at the multiple degradation points.

11. The battery management method according to claim 10, wherein the generating the voltage-capacity profiles includes:
generating dQ/dV profiles representing differential capacity values of the management target battery relative to voltage at the multiple degradation points, based on the low-rate discharge data; and
generating the voltage-capacity profiles based on the dQ/dV profiles at the multiple degradation points.

12. The battery management method according to claim 11, wherein the identifying the boundary voltage includes:
identifying the boundary voltage based on patterns of the dQ/dV profiles.

13. The battery management method according to claim 9, wherein the estimating the second SOC-OCV profile includes:
applying the upper capacity degradation rate to the first SOC-OCV profile at an upper section of the boundary voltage and the lower capacity degradation rate to the first SOC-OCV profile at a lower section of the boundary voltage to generate a corrected SOC-OCV profile at the MOL point.

14. The battery management method according to claim 13, wherein the estimating the second SOC-OCV profile includes:
performing interpolation on the corrected SOC-OCV profile with respect to SOC units to generate an interpolated SOC-OCV profile; and
applying an open-circuit voltage (OCV) offset to the interpolated SOC-OCV profile to estimate the second SOC-OCV profile.

15. The battery management method according to claim 9, wherein the management target battery includes an NCM battery containing nickel, cobalt, and manganese, and
wherein the upper voltage degradation characteristic and the lower voltage degradation characteristic arise due to compositional elements of the NCM battery.

16. The battery management method according to claim 15, wherein the upper voltage degradation characteristic is determined based on capacity degradation caused by a redox reaction of nickel and cobalt, and
wherein the lower voltage degradation characteristic is determined based on capacity manifestation caused by a redox reaction of manganese.

17. A non-transitory computer-readable storage medium storing a program that, when executed, causes a computer to perform a method comprising:
acquiring battery data of a management target battery measured multiple degradation points;
generating a first state of charge-open circuit voltage (SOC-OCV) profile at a beginning-of-life (BOL) point and voltage-capacity profiles of the management target battery at the multiple degradation points, based on the battery data;
identifying a boundary voltage that distinguishes an upper voltage degradation characteristic with an upper capacity degradation rate and a lower voltage degradation characteristic with a lower capacity degradation rate, based on the voltage-capacity profiles; and
estimating a second SOC-OCV profile at a middle-of-life (MOL) point, based on the upper capacity degradation rate, the lower capacity degradation rate, and the first SOC-OCV profile.
